# EUROPEAN PATENT APPLICATION

(11) **EP 4 273 564 A1**
(43) Date of publication of application: **08.11.2023**
(21) Application number: 22171150.0
(22) Date of filing: 02.05.2022
(51) Int. Cl.: G01R 31/08

(54) **APPARATUS, SYSTEM AND METHOD FOR DETECTING ANOMALIES IN A GRID**

(71) Applicant: Siemens Aktiengesellschaft, 80333 München (DE); Friedrich-Alexander-Universität Erlangen-Nürnberg, 91054 Erlangen (DE)
(72) Inventor: Kienberger, Melanie, 94360 Mitterfels (DE); Stübinger, Johanes, 95349 Thurnau (DE); Al Hage Ali, Ali, 91056 Erlangen (DE); Thamm, Aleksandra, 90762 Fürth (DE); Zacharias, Dominik, 90765 Fürth (DE); Amschler, Benjamin, 95500 Heinersreuth (DE); Thamm, Florian, 95500 Heinersreuth90762 Fürth (DE)
(74) Representative: Siemens Patent Attorneys

(57) **Abstract**

Apparatus, System and Method for detecting anomalies in a grid are disclosed. The method comprising transforming data acquired from the grid (110, 110A-110C) based on at least one of a Fast Fourier Transformation (FFT) and a spectrogram of the data, wherein the data acquired comprises data associated with at least one of grid voltage, grid current, grid frequency, phase; fitting the data using a fitting function initialized using at least the transformed data, wherein the fitting function includes at least one of a sinusoidal function; or generating a lower representation of at least one of the data acquired and the transformed data; and detecting the anomaly in the grid (110, 110A-110C) based on at least one outlier detected in the fitted data or the lower representation of data using at least one of a parameter deviation and the similarity index.

## Description

The present disclosure relates in general to grids in an industrial environment. Particularly, the present disclosure relates to identifying anomalies in the grids.

The frequency converters used in a powertrain are operated on a grid network/grid. When a large number of frequency converters are used, a negative impact may be seen on the grid feedback. On the other hand, unstable grids may also have a negative impact on the availability of a frequency converter. In the event of anomalies, such as voltage interruptions or voltage drops in the mains voltage, failure of the frequency converter may be inevitable.

Analysis of the grid may be performed with additional measurement sensors, network analyzers and technical experts. Such analysis may be expensive due to the cost of the hardware and the technical expert involved. Accordingly, a continuous analysis is generally not possible. Creeping changes in the mains voltage are usually not recognized, which is why a failure is often the immediate consequence. Special features of the grid network may not be considered by such analysis methods. Further, the use of expensive hardware may result in analysis that is decoupled from the drive system.

If anomalies are to be detected without the expensive measuring sensors, process signals (data from the frequency converter) must be used as indicators. However, this results in various technical problems that make automatic detection of anomalies more difficult. For example, the process signals can differ between machines and in different operating phases. Further, anomalies can manifest themselves differently across different machines, accordingly, defining deviations that lead to anomalies is challenging. Therefore, the requirement of a technical expert may become inevitable. In addition, anomalies that are identified at the frequency converters themselves may be based on fixed threshold values, which results in anomalies being detected late/not at all. This can lead to failure without warning.

Accordingly, the present techniques to analyze grid for anomalies may benefit from improvements.

The object of the present invention is to analyze the grid for anomalies without additional equipment, providing an integrated end-to-end solution that is compatible with the powertrain. Further, the object of the present invention is to analyze the grid for anomalies automatically without the need for a technical expert.

In an example of the present invention, the object of the present invention is achieved by a method of detecting at least one anomaly in a grid comprising transforming data acquired from the grid based on at least one of a Fast Fourier Transformation (FFT) and a spectrogram of the data, wherein the data acquired comprises data associated with at least one of grid voltage, grid current, grid frequency, phase; fitting the data using a fitting function initialized using at least the transformed data, wherein the fitting function includes at least one of a sinusoidal function; or generating a lower representation of at least one of the data acquired and the transformed data; and detecting the anomaly in the grid based on at least one outlier detected in the fitted data or the lower representation of data using at least one of a parameter deviation and the similarity index.

In another example, the object is achieved by an apparatus for detecting at least one anomaly in a grid comprising a communication interface communicatively coupled to a frequency convertor coupled to the grid; a grid analytics module communicatively coupled to the communication interface capable of receiving data associated with the grid via at least the communication interface, wherein the grid analytics module is configured to perform steps in method disclosed herein.

In another example, the object is achieved by a system for detecting anomalies in one or more grids comprising a server configured to coordinate execution of one or more the method steps disclosed herein, executable in a distributed computing environment.

In yet another example, the object is achieved by a computer readable medium having machine-readable instructions stored therein, which when executed by a processing unit, cause the processing unit to perform steps according to the method disclosed herein.

The present invention advantageously discloses approaches from signaling technology and machine learning that may be used in parallel or in combination to detect anomalies in the grid. The term "grid" as used herein refers to an industrial facility that transports electricity from a power generator (hydroelectric, nuclear, coal-powered, etc.) to a customer site. The customer site may be any industrial environment such as a plant comprising one or more machines. As an example, the present invention discloses a plant that includes drive systems, frequency/power converters, etc.

Non limiting examples of anomalies in the grid include types of anomalies were Voltage drop (no voltage at all for a few seconds), Voltage decrease (smaller amplitude than in the training phase) and Voltage increase (higher amplitude than in the training phase). Further, other anomalies include Harmonics anomalies, based on harmonic waves.

The benefit of the present invention is that the anomalies in the grid are detected without the need of expensive hardware, such as network analyzers or technical experts. By avoiding use of separate hardware to analyze the grid, the present invention ensures that the anomaly detection is integrated with the drive system.

The present invention proposes a fingerprint phase that is used to tune the transformation functions such as FFT and spectrogram and the fitting functions. Therefore, the present invention provides a customized "plug-and-play" solution, which is implementable at the customer site. In other words, the present invention advantageously considers specifics of the customer site is considered while detecting anomalies. By this, the anomalies detected according to the present invention are accurate in comparison with standard anomaly detection methods that have a fixed threshold to detect anomalies. Furthermore, the present invention has high scalability which is achieved by the simple expandability of the flexibly usable computing units.

The method of detecting an anomaly according to the present invention includes transforming data acquired from the grid based on at least one of a Fast Fourier Transformation (FFT) and a spectrogram of the data. The data acquired comprises data associated with at least one of grid voltage, grid current, grid frequency, phase. Other data can also be acquired in relation to the data from process of electricity generation, transmission, distribution and consumption by the machines in the plant. The data accordingly may include electrical information from distribution stations, distribution switch stations, electricity meters, and non-electrical information such as operating conditions of the plant.

When the data is transformed based on the spectrogram, the method may further include transforming the acquired data into the spectrogram representing time-varying frequencies in the acquired data; and splitting the spectrogram into sub-spectrograms, wherein the sub-spectrograms comprise snippets of the spectrogram for varying time intervals. The sub-spectrograms enable a similarity analysis to be performed.

In an embodiment, sub-spectrograms are generated in the fingerprint phase and the similarity analysis may be further used to train an unsupervised learning model to determine the outliers. Therefore, the method may include training an unsupervised learning model, such as a support vector machine and a Gaussian mixture model based on similarity indexes generated for the sub-spectrums associated with the fingerprint data, wherein the trained support vector machine is configured to identify patterns in the similarity indexes of the sub-spectrums associated with the fingerprint data. The patterns identified in the fingerprint phase are compared to patterns identified during runtime/real time operation of the customer site. The comparison is used to detect the outliers.

The advantage of signal processing techniques i.e., FFT and the spectrogram is that the data acquired is often in high frequency and therefore difficult to analyze for outliers. The transformations reduce the complexity of the data. For example, the spectrogram converts the high frequency data into time-varying frequencies. The transformation enables determination of outliers when the fitting function is applied.

Accordingly, the method includes fitting the data using a fitting function initialized using at least the transformed data, wherein the fitting function includes at least one of a sinusoidal function. The method may further include fitting at least one parameter of the sinusoidal functions onto the transformed data, wherein the parameter includes at least one of amplitude, offset, frequency and phase of the sinusoidal function.

By this the present invention advantageous uses a statistical approach to compare the parameter estimates of a sinusoidal curve as well as the resulting outliers to detect anomalies.

To enable a customized detection of the outliers, the method may include a fingerprint phase or a training phase. In the fingerprint phase the method may include fitting parameter of the sinusoidal function using fingerprint data, creating confidence intervals, and determining the outliers based on estimated and actual values.

The present invention proposes the use of machine learning techniques in addition or in parallel with the sinusoidal function. Accordingly, the method includes generating a lower representation of the transformed data. As used herein "lower representation" refers to a representation of the data acquired and/or the transformed data where the most important features are extracted. In an embodiment, the most important features are extracted by encoding the data acquired and/or the transformed data using a minimal loss function. For example, an autoencoder is used. The autoencoder is a machine learning model that is configured to learn the encodings in an unsupervised manner. The aim of an autoencoder is to learn a lower representation (encoding) for the data acquired and/or the transformed data, which may be higher dimensional data. The dimensionality reduction is performed by training the autoencoder to capture the most important parts of the data acquired and/or the transformed data.

Therefore, the method step of generating the lower representation of at least one of the data acquired and/or the transformed data may further include compressing the data acquired from the grid using a trained autoencoder, wherein the autoencoder is trained based on a minimal loss function used to extract significant features from a fingerprint data associated with the grid. As used herein the fingerprint data comprises data associated with at least one of historical operation of the grid and standard operating parameters of the grid. Examples of fingerprint data include sensor data from the grid, grid voltage, digital representations of the grid, transmission and distribution information of the grid, etc. The method may also include generating encoded data from the compressed data as an output of the trained autoencoder; and classifying datapoints in the encoded data as the outlier using a trained unsupervised learning module, wherein the unsupervised learning module is trained using trained encoded data generated from the fingerprint data.

It will be appreciated that the Autoencoder is an example of a machine learning technique to reduce the dimensionality of the data acquired and/or the transformed data. Other dimensionality reduction techniques include nonlinear Principal component analysis (PCA) and its types, Gaussian process latent variable models, Maximum variance unfolding, etc.

In an embodiment, the signal processing techniques is combined with machine learning techniques to enable classification of the datapoints to determine the outliers. The method may include compressing the spectrogram using the trained autoencoder; generating the encoded data from the compressed data as the output of the trained autoencoder; and classifying the datapoints in the encoded data as the outlier using the trained unsupervised learning module. The technical effect of the combination of machine learning techniques with the signal processing techniques is that the dimensionality of the transformed data is reduced further and thereby has a synergistic effect that enables faster classification and determination of the outliers.

The fitting function is also advantageously made accurate and relevant to the customer site (i.e. the grid providing power supply to the customer site) by using the fingerprint data to configure the parameters of the fitting function. Accordingly, the method may include initializing the fitting function based on at least one transformation function performed on the fingerprint data, wherein the transformation function results in at least one of a spectrogram of the fingerprint data and a FFT of the fingerprint data.

The method includes detecting the anomaly in the grid based on the outlier detected in the fitted data and/or the lower representation of data using at least one of a parameter deviation and the similarity index. The method may include detecting the outlier in the fitted data or the lower representation of data using at least one of a parameter deviation and the similarity index. The method may further include determining if the parameter deviation falls outside a confidence interval generated for the fingerprint data, wherein the confidence interval is generated based on a risk aversion parameter associated with the grid.

determining if the mean square error estimated for the fitted data is greater than a mean square error estimated for the fingerprint data.

Additionally, the method may include calculating the similarity index for the sub-spectrograms based on structural parameters of the sub-spectrograms; classifying the datapoints in the fitted data as the outlier based on the calculated similarity index using the trained unsupervised learning module, wherein the trained unsupervised learning module is trained based on similarity index generated for sub-spectrums associated with the fingerprint data.

Furthermore, the method may include determining a certainty measure for the outlier based on at least one of a distance threshold and a probability threshold, wherein the distance threshold is the distance that determines whether a datapoint is classified as the outlier, wherein the probability threshold is a cut-off probability that determines whether the datapoint is classified as the outlier and wherein the distance threshold and the probability threshold are generated based on the fingerprint data; and detecting the anomaly of the outlier based on parameters associated with the outlier, wherein the outlier parameters include the certainty measure.

The method may also include generating at least one control signal to control one or more operating conditions of the grid; and generating a notification comprising at least the detected anomaly, wherein an external control signal to control the operating conditions of the grid is triggerable upon receipt of the notification.

The present invention further includes a method to generating the trained unsupervised learning model according to at least one of the preceding claims, the method comprising training at least one of a support vector machine and a Gaussian mixture model based on the similarity indexes generated for the sub-spectrums associated with the fingerprint data, wherein the trained support vector machine is configured to identify patterns in the similarity indexes of the sub-spectrums associated with the fingerprint data; and/or training the support vector machine and/or the Gaussian mixture model based on trained encoded data generated from the fingerprint data, wherein the trained encoded data comprises the significant features extracted from the fingerprint data and wherein the trained encoded data is generated using the trained autoencoder comprising at least one hidden encoder layer and at least one decoder layer.

Training of the unsupervised model is implemented by using the similarity indexes and/or trained encoded data provided as input to support vector machine and/or Gaussian mixture models. In an embodiment the support vector machine is a One-Class Support Vector Machine. The purpose of a SVM is to determine in which category or class a new unseen data point belongs to. Accordingly, the technical effect of support vector machines is the effective classification when high dimensional data associated with grid voltage, grid current, grid frequency, phase is analyzed. In an unsupervised environment, the usage of a one class Support Vector Machine would imply the assumption that the training data has no anomaly in it since, per definition, the training data only has one class. After the training is done, the algorithm can determine when the machine starts to deteriorate.

Accordingly, the One Class Support Vector Machine effectively classifies when large volume of data is available.

As indicated above the support vector machine can be replaced with Gaussian Mixture models. For the fingerprint phase, the feature representations/ features (either by spectrograms or by autoencoders) may be clustered using Gaussian Mixture Models. If autoencoders are used for feature extraction, special variational autoencoders can be used to achieve the technical effect of enforcing Gaussian distributions in latent space. Accordingly, the features identified may be modeled by Gaussian Mixture Models at the end of the fingerprint phase. If a datapoint is encoded in runtime, the probability of belonging to the distribution of the fingerprint data is checked using Gaussian distributions. The technical effect of the Gaussian Mixture Models is that the probability can calculated whether the datapoint in the real time phase contains an anomaly or not. In addition to the Gaussian Mixture Models other models can also be used to achieve the same technical effect.

The trained encoded data used herein above is generated using the trained autoencoder comprising at least one hidden encoder layer and at least one decoder layer. Accordingly, the present invention further includes a method of generating the trained autoencoder according to one or more of the preceding claims, the method comprising fitting the fingerprint data associated with the grid to an autoencoder, wherein the fingerprint data comprises data associated with at least one of historical operation of the grid and standard operating parameters of the grid; extracting significant features from the fitted fingerprint data using a minimum loss function; and generating the hidden encoder layer and the decoder layer of the autoencoder as linear layers.

The present invention further includes an apparatus for detecting anomalies in the grid. The apparatus includes a communication interface communicatively coupled to a frequency convertor coupled to the grid; a grid analytics module communicatively coupled to the communication interface capable of receiving data associated with the grid via at least the communication interface, wherein the grid analytics module is configured to perform steps in method disclosed herein above. The apparatus may be an edge computing device provided within the customer site/industrial environment. Accordingly, the present invention is implemented without any additional sensing device that may be expensive. The same may be implemented by any computing device that receives input from the frequency convertor of the grid. In an embodiment, the grid analytics module is implemented as a microservice.

To further enable real-time identification of anomalies the present invention also provides a system for detecting anomalies in one or more grids comprising a server configured to coordinate execution of one or more the method steps disclosed hereinabove. The method steps may be executed in a distributed computing environment, such as a cloud computing platform with distributed computing resources connected via a network external to network of the customer site. Cloud computing enables a customer to interact via the internet with distributed servers. Customers/i.e. multiple industrial environments access these servers from their own network and use them for their own purposes. The server may be configured to initialize a fitting function for the fingerprint data based on at least one transformation function performed on the fingerprint data, wherein the transformation function results in at least one of a spectrogram of the fingerprint data and a FFT of the fingerprint data. The server may be further configured to generate the trained unsupervised learning module and the trained autoencoder. Furthermore, the server may be configured to store the fitting function, the transformation function, the trained autoencoder and the trained unsupervised learning module.

The technical effect of the server generating the fitting function, the trained unsupervised learning module and the trained autoencoder is that the apparatus at the customer site configured to detect at least one anomaly in the grid quickly. This is achieved using a call function by the apparatus to call at least one of the fitting function, the transformation function, the trained autoencoder and the trained unsupervised learning module generated by the server/stored in a database of the system. The fitting function, the transformation function, the trained autoencoder and the trained unsupervised learning module are run as plug and play software with the data coming in real-time from the grid/frequency convertor. The present invention splits the processing of the fingerprint data from the processing of the data from real-time. This advantageously enables the compute intensive actions to be performed on the cloud computing platform and the time sensitive process to be performed at the customer site.

The foregoing has outlined rather broadly the technical features of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiments disclosed as a basis for modifying or designing other structures for carrying out the same purposes of the present disclosure. Those skilled in the art will also realize that such equivalent constructions do not depart from the scope of the disclosure in its broadest form.

Below, the invention is described using the embodiments illustrated in the figures.
- Fig. 1: illustrates an industrial environment including an apparatus for detecting anomalies in a grid, according to an embodiment of the present invention;
- Fig. 2: illustrates a fingerprint phase and a run-time phase of detecting anomalies in the grid, according to an embodiment of the present invention;
- Fig. 3: illustrates a system for detecting anomalies associated with multiple grids, according to an embodiment of the present invention;
- Fig. 4: illustrates a method of detecting anomalies in a grid, according to an embodiment of the present invention; and
- Fig. 5: illustrates a method for generating the trained autoencoder, according to an embodiment of the present invention.

Hereinafter, embodiments for carrying out the present invention are described in detail. The various embodiments are described with reference to the drawings, wherein like reference numerals are used to refer to like elements throughout. In the following description, for purpose of explanation, numerous specific details are set forth in order to provide a thorough understanding of one or more embodiments. It may be evident that such embodiments may be practiced without these specific details.

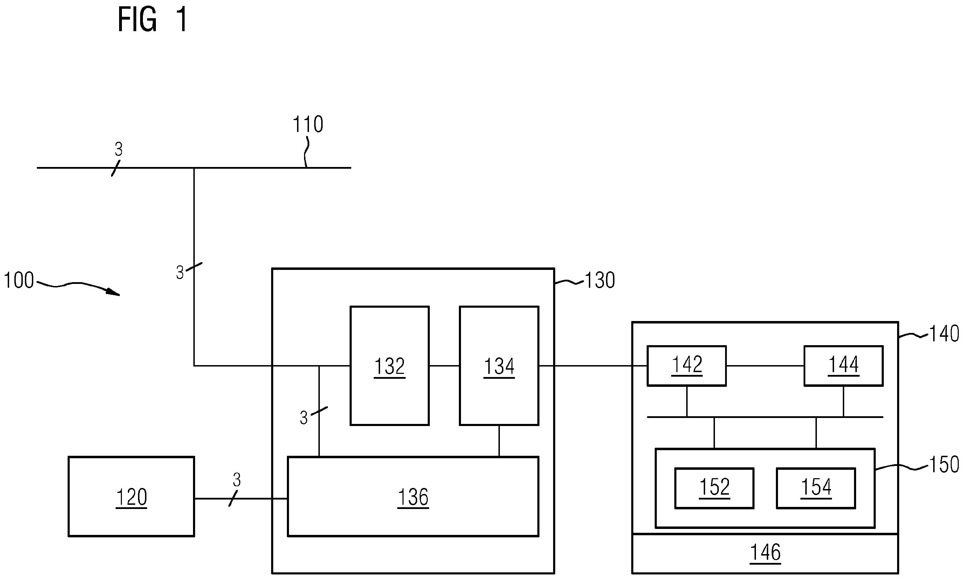

Fig. 1 illustrates an industrial environment 100 including an apparatus 140 for detecting anomalies in a grid 110, according to an embodiment of the present invention. The industrial environment also includes a motor 120 and a frequency converter 130. The frequency converter 130 includes a voltage sensing module 132, a control unit 134 and a power block module 136 communicatively coupled to the motor 120. For collecting the data from the grid 110, the frequency convertor uses the voltage sensing module 132 to trace data and write it into a buffer readable by the apparatus 140.

The apparatus 140 may be an Industrial Edge Device (IED) and includes a communication interface 142 communicatively coupled to the frequency convertor 130 and configured to read the data written by the voltage sensing module 132. The apparatus 140 also includes a database 144 and an application module 150. The application module 150 includes a grid analytics microservice 152 and additional microservices 154 running on an industrial operating system 146.

It will be appreciated by a person skilled in the art that the apparatus 140 may be implemented to include one or more computing devices communicatively coupled to each other with in the industrial environment 100. In an embodiment, the interconnected computing devices may also be referred in some embodiments as an edge platform. Accordingly, the block 140 in Fig. 1 may also be an edge computing platform within the industrial environment 100. The microservices 152, 154 are either stored directly on the premises or on a server in the cloud. Further the microservices 152, 154 can be distributed onto the different computing devices constituting the edge platform. The microservices 152, 154 then run on the Industrial Edge can extract data directly from the frequency convertor 130.

The present invention is directed towards the grid analytics microservice 152. The grid analytics microservice 152 receives the data from the frequency convertor 130 and transforms the data acquired from the grid based on at least one of a Fast Fourier Transformation (FFT) and a spectrogram of the data, wherein the data acquired comprises data associated with at least one of grid voltage, grid current, grid frequency, phase. The grid analytics microservice 152 is configured to fit the data using a fitting function initialized using at least the transformed data, wherein the fitting function includes at least one of a sinusoidal function. Alternatively, the grid analytics microservice generates a lower representation of the data acquired and/or the transformed data. In an embodiment, when the data is transformed using a spectrogram, the similarities in sub-spectrums of the spectrogram are used to train an unsupervised learning module used to generate the lower representation. The grid analytics microservice 152 detects the anomaly in the grid based on at least one outlier detected in the fitted data or the lower representation of data using at least one of a parameter deviation and the similarity index.

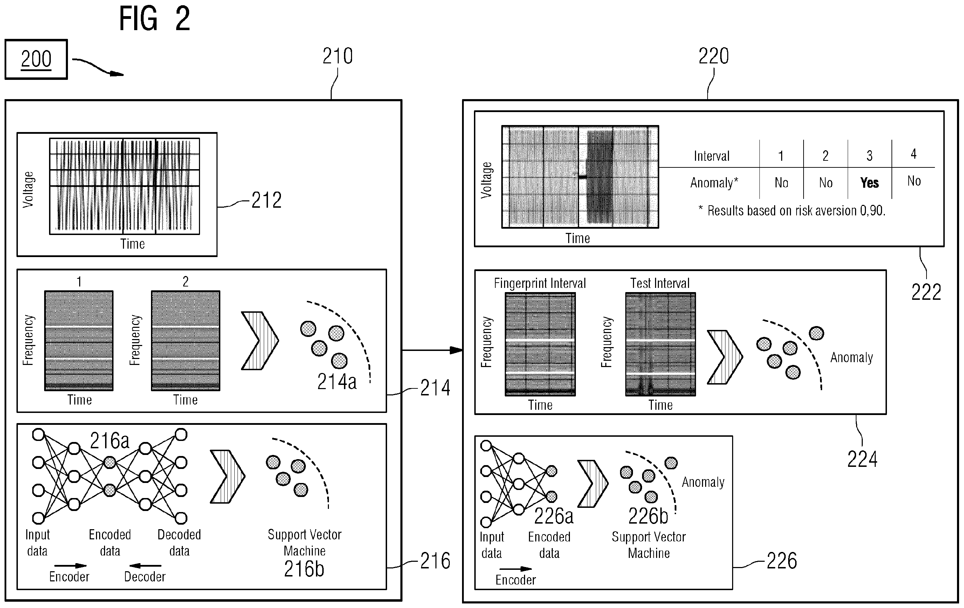

The present invention provides multiple approaches that can be used individually or in combination to accurately determine anomalies in the grid 110. The approaches and the stages of the methodology is discussed further in Figure 2.

Fig. 2 illustrates a fingerprint phase 210 and a run-time phase 220 of detecting anomalies in the grid, according to an embodiment of the present invention.

The fingerprint phase 210 refers to a phase where the data received at the apparatus 140 is labeled as fingerprint data. The data labeled with Fingerprint is used to find features that describe the "normal" status. In the productive or run-time phase 220, unseen data i.e. data from the frequency convertor 130 will be processed and compared to the fingerprint data in the fingerprint phase. If the data is significantly different from the fingerprint phase 210, the sample is classified as an anomaly.

In the fingerprint phase 210, the steps performed in each of the approaches 212, 214 and 214 start with loading the fingerprint data (Example historical operation data of the grid and standard operating parameters). Similarly, in the run-time phase 220, the data from the frequency convertor 130 is loaded.

The sinusoidal approach 212 includes cutting the fingerprint data into intervals. For each interval, parameters are fitted using a sinusoidal fitting function. The median is selected for each of the anomalies. Based on that median a confidence interval is created. In an embodiment, the confidence interval is generated based on a risk aversion parameter associated with the grid 110. The risk aversion parameter is introduced as a way for the customer to influence the accuracy of the anomaly detection to customize it to the needs of the industrial environment. To be more precise, the customer would be able to determine how strongly the grid analytics microservice 152 should detect anomalies.

In the run-time phase 220, the data is loaded and cut into intervals. For each interval, the parameters are fitted using the sinusoidal fitting function. In an embodiment, a mean squared error (MSE) is calculated and compared to its indicator of the Fingerprint phase. If the fitted parameter are not within their respective confidence interval from the fingerprint phase, the data received in run-time is declared as anomaly. In an embodiment, the severeness of the anomaly is displayed using a User Interface with a color-coded illustration of the severeness, such as a traffic light system.

The spectrogram-based approach 214 in the fingerprint phase 220 involves loading of the fingerprint data and transformation into spectrograms. Then the complexity is reduced via Canny Edge. Afterwards, two intervals are compared to each other via the Structural Similarity Index Measure algorithm (SSIM). The SSIM calculates the similarity between two pictures of the same size. The resulting similarity score is used as a feature describing the normal state. To refine this, the intervals are additionally divided into segments by the y-value of the spectrogram, i.e. the frequency. The resulting similarities are used to train a One Class Support Vector Machine 214a. In an embodiment, the spectrogram approach 214 includes introduction of n-gram sequences in which the similarities can be calculated in respect of their immediate neighbors.

In the run-time phase 220, data i.e. data from the frequency convertor 130 (also referred to as test sample) in the same size as the fingerprint interval, is loaded and transformed into a spectrogram. Afterwards, the complexity of the spectrogram is reduced via Canny Edge. Then, the test interval is compared to each interval that was sampled in the fingerprint. The resulting similarity scores for both voltage signals are then sent to the Once Class Support Vector Machine, which predicts the categorization as either "normal" or "anomaly". For example, if six intervals were picked in the fingerprint phase, there are also six predictions made by the Once Class Support Vector Machine. To get a final decision if the data is an anomaly or not, a majority voting is used on the predictions. If the predictions are 50:50, the model may not decide but declare the datapoint as "unsure".

In the fingerprint phase 210 the autoencoder approach 216 provides that the fingerprint data is preprocessed and reshaped to fit into the input shape of the Autoencoder 216a. Therefore, the fingerprint data may be first rearranged with a sliding window which results in multiple overlapping windows from one sequence or interval. The intervals are then transformed into a spectrogram as illustrated in the spectrogram approach 214. The spectrograms are randomly grouped into batches. The autoencoder 216a is used to train the feature reduction from the spectrograms. After that, the encoder 216a reduces the feature dimension and extracts the strongest features. These features are then used to train a One Class Support Vector Machine 216b.

In the run-time phase 220 the trained autoencoder 226a calculates the main features of the preprocessed data from the frequency convertor 130. The One Class Support Vector Machine 226b is used to predict anomalies. For example, the spectrogram is compressed the spectrogram using the trained autoencoder 226a. The encoded data from the compressed data is generated as the output of the trained autoencoder 226a. The datapoints in the encoded data are classified as the outlier using the One Class Support Vector Machine 226b.

The method of the present invention may include determining the precision of anomaly detection of the sinusoidal approach 222, the spectrogram approach 224 and the autoencoder approach 226. Further, determining the most suitable approach based on the precision. The parameters to determine suitability of the approaches includes the computing device used to execute the grid analytics microservice 152.

The present invention may also be implemented in a cloud computing environment. For example, a customer may use the grid analytics microservice provided as an application hosted on a cloud computing platform. In some embodiments, multiple industrial environments and associated grids can be monitored for anomalies using the grid analytics application.

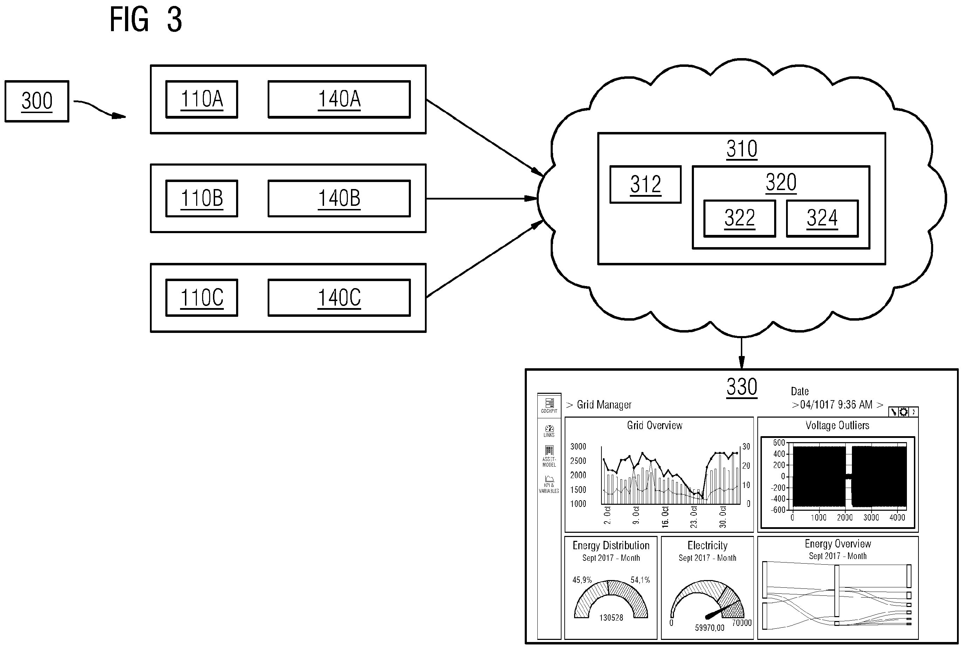

Fig. 3 illustrates a system 300 for detecting anomalies associated with multiple grids 110A, 110B and 110c, according to an embodiment of the present invention. The grids 110A, 110B, 110C are associated with a respective apparatus 140A, 140B and 140C, which can each execute a grid analytics microservice (such as the grid analytics microservice 152 in Fig. 1).

The historical operation data of the grids 110A, 110B and 110C and the associated industrial environment may be stored as fingerprint data on a database communicatively coupled to the server 310.

The system 300 includes a server 310 hosted on a cloud computing platform. The server 310 may further include a fitting module 312 and a training module 320. The fitting module 312 when executed by the server initializes a fitting function for the fingerprint data based on at least one transformation function performed on the fingerprint data, wherein the output of transformation function is a spectrogram of the fingerprint data and/or a FFT of the fingerprint data. In an embodiment, the fitting function may be selected by an operator of the grids 110A-110C or the industrial environment. In another embodiment, the fitting function is selected based on parameters provided by the operator such as volume of fingerprint data to be analyzed, expected accuracy of the anomaly detection, nature of process in the industrial environment and sensitivity of the process to grid anomalies.

The training module 320 may further include a learning module 322 and an autoencoder 324. The learning module 322 is configured to generate a trained unsupervised learning module by training a support vector machine and/or a Gaussian mixture model based on similarity indexes generated for the sub-spectrums associated with the fingerprint data. The learning module 322 is configured to generate the trained support vector machine. The trained support vector machine is configured to identify patterns in the similarity indexes of the sub-spectrums associated with the fingerprint data. The learning module 322 is also configured to train the support vector machine and/or the Gaussian mixture model based on trained encoded data generated from the fingerprint data, wherein the trained encoded data comprises the significant features extracted from the fingerprint data and wherein the trained encoded data is generated by training the autoencoder 324 comprising at least one hidden encoder layer and at least one decoder layer.

The autoencoder 324 is trained by fitting the fingerprint data associated with the grids 110A-110C to the autoencoder 324, wherein the fingerprint data comprises data associated with at least one of historical operation of the grids 110A-110C and standard operating parameters of the grids 110A-110C and by extracting significant features from the fitted fingerprint data using a minimum loss function. The trained autoencoder is generated with the hidden encoder layer and the decoder layer of the autoencoder as linear layers.

The server 310 is configured to store the fitting function, the transformation function, the trained autoencoder and the trained unsupervised learning module in the database for reuse/retraining. In an embodiment, the apparatus 140A-140C are configured to detect at least one anomaly in the associated grids 110A-110C using at least one of the fitting function, the transformation function, the trained autoencoder and the trained unsupervised learning module generated by the server 310.

The system 300 also includes a Graphical User Interface (GUI) 330 that displays metrics such as Grid Overview, Voltage Outliers, Energy Distribution, Electricity, Energy Overview, etc. The detected anomalies are displayed on the GUI 330 and is accessed by a client the cloud computing platform and/or operator of the grids/industrial environment.

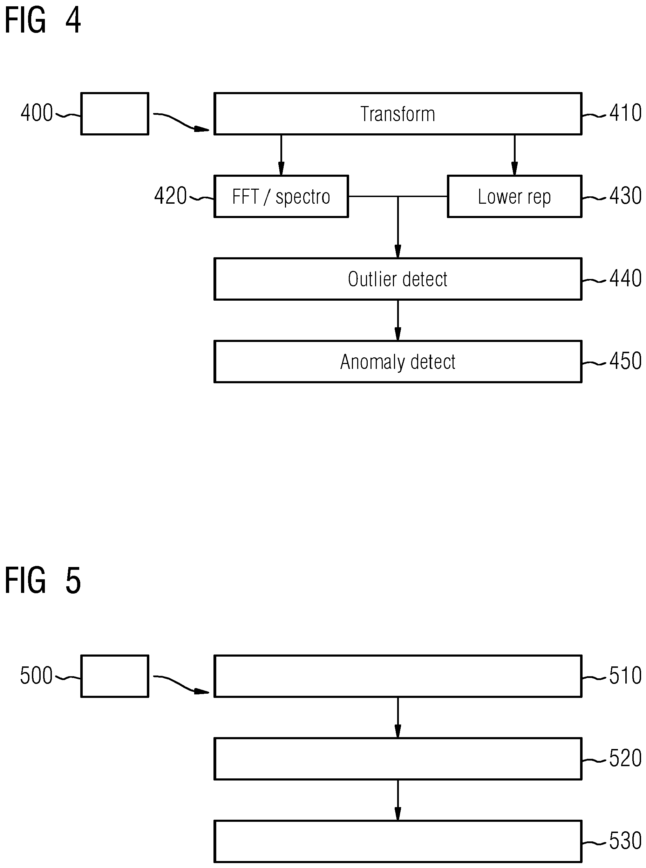

Fig. 4 illustrates a method 400 of detecting anomalies in a grid, according to an embodiment of the present invention.

The method 400 begins at step 410 by transforming data acquired from the grid based on a Fast Fourier Transformation (FFT) and/or a spectrogram of the data. The data acquired comprises data associated with at least one of grid voltage, grid current, grid frequency, phase. Other data can also be acquired in relation to the data from process of electricity generation, transmission, distribution and consumption by the machines in the plant. The data accordingly may include electrical information from distribution stations, distribution switch stations, electricity meters, and non-electrical information such as operating conditions of the plant.

When the data is transformed based on the spectrogram, the method may further include transforming the acquired data into the spectrogram representing time-varying frequencies in the acquired data; and splitting the spectrogram into sub-spectrograms, wherein the sub-spectrograms comprise snippets of the spectrogram for varying time intervals. The sub-spectrograms enable a similarity analysis to be performed.

In an embodiment, the similarity analysis may be further used to train an unsupervised learning model to determine the outliers. Therefore, the method may also include training an unsupervised learning model, such as a support vector machine and a Gaussian mixture model based on similarity indexes generated for the sub-spectrums associated with the fingerprint data, wherein the trained support vector machine is configured to identify patterns in the similarity indexes of the sub-spectrums associated with the fingerprint data. The patterns identified in the fingerprint phase are compared to patterns identified during runtime/real time operation of the customer site. The comparison is used to detect the outliers.

Step 420 includes fitting the data using a fitting function initialized using at least the transformed data, wherein the fitting function includes at least one of a sinusoidal function. The method may further include fitting at least one parameter of the sinusoidal functions onto the transformed data, wherein the parameter includes at least one of amplitude, offset, frequency and phase of the sinusoidal function.

Step 430 includes generating a lower representation of the transformed data. As used herein "lower representation" refers to a representation of the data acquired and/or the transformed data where the most important features are extracted. In an embodiment, the most important features are extracted by encoding the data acquired and/or the transformed data using a minimal loss function. For example, an autoencoder is used.

As shown in Fig. 4, the steps 420 and 430 may be performed alternatively. The present invention may also include a step to determine which alternate approach to use based on the type of data, the compute power of the apparatus performing the outlier detection and/or the accuracy expected from the detection of outliers. For example, the autoencoder-based approach may not be feasible for longer signals because the performance may take too long. The alternate steps 420 and 430 may for example be chosen based on grouping of highfrequency time series data from sensors or machinery processes that are used for predictive maintenance.

Step 440 includes detecting one or more outliers in the fitted data and/or the lower representation of data using at least one of a parameter deviation and the similarity index. Accordingly, step 440 may further include determining if the parameter deviation falls outside a confidence interval generated for the fingerprint data, wherein the confidence interval is generated based on a risk aversion parameter associated with the grid and determining if the mean square error estimated for the fitted data is greater than a mean square error estimated for the fingerprint data.

For example, in the fingerprint phase the fingerprint data is loaded and cut it into different intervals. For each interval, parameters are fitted. The median is selected for each of those indicators. Based on that median a confidence interval is created. The run-time data from the grid according to the method 400 is received and is followed by loading the data and cutting the data into intervals. For each interval, the parameters are fitted. If the fitted parameters in run-time are not within their respective confidence interval from the fingerprint phase, the data received in run-time is declared as an outlier.

In another example, in the fingerprint phase the fingerprint data is loaded the raw data and transforms it into spectrograms. Then the complexity is reduced via Canny Edge. Afterwards, two fingerprint sub-spectrograms are compared to each other via the Structural Similarity Index Measure algorithm (*SSIM). The resulting similarities are used to train a One Class Support Vector Machine. The method 400 in run-time also performs the steps related to extraction the features as in the data from the grid. The similarities between the sub-spectrograms in real-time data and the fingerprint sub-spectrograms are used to predict the whether the datapoint is an outlier. For example, the prediction is performed by a Majority Voting method.

In yet another example, in the fingerprint phase, the fingerprint data is preprocessed and reshaped to fit into the input shape of an autoencoder. Accordingly, the fingerprint data may be rearranged with a sliding window which results in multiple overlapping windows from one sequence or interval. Those windows are then transformed into a spectrogram and randomly grouped into batches. The autoencoder is used to train the feature reduction from those spectrograms. After that, the encoder reduces the feature dimension and extracts the strongest features. These features are then used to train a One Class Support Vector Machine (OC SVM). In run-time the trained autoencoder calculates the main features of the preprocessed data from the grid. The OC SVM predicts the status (outlier/not outlier) of the data based on these main features.

Fig. 5 illustrates a method 500 for generating the trained autoencoder, according to an embodiment of the present invention.

The method 500 includes step 510 comprising fitting the fingerprint data associated with the grid to the autoencoder. Step 520 includes extracting significant features from the fitted fingerprint data using a minimum loss function. Step 530 includes generating the hidden encoder layer and the decoder layer of the autoencoder as linear layers. According to method 500 the amount of fingerprint data is reduced to create a format which contains the essential features due by prioritizing different aspects of the fingerprint data. The fingerprint data then is reconstructed with the decoder. In other words, the decoder rebuilds an output that resembles the input data. Afterwards, the difference between the input data and the reconstructed one creates a reconstruction error. The reconstruction error is calculated by minimizing a loss function that penalizes the output for being too dissimilar to the input. The trained autoencoder generated according to method 500 at step 530 provides an encoder-decoder concept where both parts can be separately activated. The advantage of that setup is the possibility to encode the fingerprint data separately, in other words, to get a reduced dimension of the feature that contains the main features about the fingerprint data.

Furthermore, the step 440 may include determining a certainty measure for the outlier based on at least one of a distance threshold and a probability threshold, wherein the distance threshold is the distance that determines whether a datapoint is classified as the outlier, wherein the probability threshold is a cut-off probability that determines whether the datapoint is classified as the outlier and wherein the distance threshold and the probability threshold are generated based on the fingerprint data; and detecting the anomaly of the outlier based on parameters associated with the outlier, wherein the outlier parameters include the certainty measure.

The method 400 further includes at step 450 detecting the anomaly in the grid based on the outlier detected. The outliers indicate one or more datapoints that are not normal. These abnormal datapoints i.e. outliers are mapped to an abnormal condition of the grid i.e. the anomaly. In an embodiment, the mapping may be performed by an unsupervised classification model such as OC SVM.

The method 400 at step 450 may also include generating at least one control signal to control one or more operating conditions of the grid; and generating a notification comprising at least the detected anomaly, wherein an external control signal to control the operating conditions of the grid is triggerable upon receipt of the notification.

The present invention can take a form of a computer program product comprising program modules accessible from computer-usable or computer-readable medium storing program code for use by or in connection with one or more computers, processors, or instruction execution system. For the purpose of this description, a computer-usable or computer-readable medium can be any apparatus that can contain, store, communicate, propagate, or transport the program for use by or in connection with the instruction execution system, apparatus, or device. The medium can be electronic, magnetic, optical, electromagnetic, infrared, or semiconductor system (or apparatus or de-vice) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and DVD. Both processors and program code for implementing each aspect of the technology can be centralized or distributed (or a combination there-of) as known to those skilled in the art.

While the present invention has been described in detail with reference to certain embodiments, it should be appreciated that the present invention is not limited to those embodiments. In view of the present disclosure, many modifications and variations would be present themselves, to those skilled in the art without departing from the scope of the various embodiments of the present invention, as described herein. The scope of the present invention is, therefore, indicated by the following claims rather than by the foregoing description. All advantageous embodiments claimed in method claims may also be apply to system/apparatus claims.

## Claims

1. A method of detecting at least one anomaly in a grid (110, 110A-110C) comprising:
transforming data acquired from the grid (110, 110A-110C) based on at least one of a Fast Fourier Transformation (FFT) and a spectrogram of the data, wherein the data acquired comprises data associated with at least one of grid voltage, grid current, grid frequency, phase;
fitting the data using a fitting function initialized using at least the transformed data, wherein the fitting function includes at least one of a sinusoidal function; or
generating a lower representation of at least one of the data acquired and the transformed data; and
detecting the anomaly in the grid (110, 110A-110C) based on at least one outlier detected in the fitted data or the lower representation of data using at least one of a parameter deviation and the similarity index.

2. The method according to claim 1, wherein generating the lower representation of the transformed data further comprising:
compressing the data acquired from the grid (110, 110A-110C) using a trained autoencoder, wherein the autoencoder is trained based on a minimal loss function used to extract significant features from a fingerprint data associated with the grid (110, 110A-110C), wherein the fingerprint data comprises data associated with at least one of historical operation of the grid (110, 110A-110C) and standard operating parameters of the grid (110, 110A-110C);
generating encoded data from the compressed data as an output of the trained autoencoder; and
classifying datapoints in the encoded data as the outlier using a trained unsupervised learning module, wherein the unsupervised learning module is trained using trained encoded data generated from the fingerprint data.

3. The method according to one of claim 1 and claim 2, further comprising:
compressing the spectrogram using the trained autoencoder (226a);
generating the encoded data from the compressed data as the output of the trained autoencoder; and
classifying the datapoints in the encoded data as the outlier using the trained unsupervised learning module (226b) .

4. The method according to one of claim 1, further comprising:
initializing the fitting function based on at least one transformation function performed on the fingerprint data, wherein the transformation function results in at least one of a spectrogram (Int 1, Int 2) of the fingerprint data and a FFT (212) of the fingerprint data.

5. The method according to claim 1, wherein fitting the data using a fitting function initialized using at least the transformed data comprises:
fitting at least one parameter of the sinusoidal functions onto the transformed data, wherein the parameter includes at least one of amplitude, offset, frequency and phase of the sinusoidal function.

6. The method according to at least one of the preceding claims, wherein detecting the anomaly in the grid (110, 110A-110C) based the outlier detected comprises:
determining if the parameter deviation falls outside a confidence interval generated for the fingerprint data, wherein the confidence interval is generated based on a risk aversion parameter associated with the grid (110, 110A-110C).
determining if the mean square error estimated for the fitted data is greater than a mean square error estimated for the fingerprint data.

7. The method according to claim 1, wherein transforming the data based on the spectrogram comprises:
transforming the acquired data into the spectrogram representing time-varying frequencies in the acquired data; and
splitting the spectrogram into sub-spectrograms, wherein the sub-spectrograms comprise snippets of the spectrogram for varying time intervals.

8. The method according to at least one of claim 1, claim 2 and claim 6, wherein detecting the anomaly in the grid (110, 110A-110C) comprises:
calculating the similarity index for the sub-spectrograms based on structural parameters of the sub-spectrograms;
classifying the datapoints in the fitted data as the outlier based on the calculated similarity index using the trained unsupervised learning module, wherein the trained unsupervised learning module is trained based on similarity index generated for sub-spectrums associated with the fingerprint data.

9. The method according one the preceding claims, further comprising:
determining a certainty measure for the outlier based on at least one of a distance threshold and a probability threshold,
wherein the distance threshold is the distance that determines whether a datapoint is classified as the outlier, wherein the probability threshold is a cut-off probability that determines whether the datapoint is classified as the outlier and
wherein the distance threshold and the probability threshold are generated based on the fingerprint data; and
detecting the anomaly of the outlier based on parameters associated with the outlier, wherein the outlier parameters include the certainty measure.

10. The method according one preceding claims, further comprising:
generating at least one control signal to control one or more operating conditions of the grid (110, 110A-110C); and
generating a notification comprising at least the detected anomaly, wherein an external control signal to control the operating conditions of the grid (110, 110A-110C) is triggerable upon receipt of the notification.

11. A computer readable medium having machine-readable instructions stored therein, which when executed by a processing unit, cause the processing unit to perform steps according to claims 1 to 10.

12. A method of generating the trained unsupervised learning model (214a) according to at least one of the preceding claims, the method comprising at least one of:
training at least one of a support vector machine and a Gaussian mixture model based on the similarity indexes generated for the sub-spectrums associated with the fingerprint data, wherein the trained support vector machine is configured to identify patterns in the similarity indexes of the sub-spectrums associated with the fingerprint data; and
training the support vector machine and/or the Gaussian mixture model based on trained encoded data generated from the fingerprint data, wherein the trained encoded data comprises the significant features extracted from the fingerprint data and wherein the trained encoded data is generated using the trained autoencoder comprising at least one hidden encoder layer and at least one decoder layer.

13. A method of generating the trained autoencoder (226a) according to one or more of the preceding claims, the method comprising:
fitting the fingerprint data associated with the grid (110, 110A-110C) to an autoencoder, wherein the fingerprint data comprises data associated with at least one of historical operation of the grid (110, 110A-110C) and standard operating parameters of the grid (110, 110A-110C);
extracting significant features from the fitted fingerprint data using a minimum loss function; and
generating the hidden encoder layer and the decoder layer of the autoencoder as linear layers.

14. An apparatus (140, 140A-140C) for detecting at least one anomaly in a grid comprising:
a communication interface communicatively coupled to a frequency convertor coupled to the grid (110, 110A-110C);
a grid analytics module (152) communicatively coupled to the communication interface capable of receiving data associated with the grid (110, 110A-110C) via at least the communication interface, wherein the grid (110, 110A-110C) analytics module is configured to perform steps in method claims 1-10, 12 and 13.

15. A system (300) for detecting anomalies in one or more grids comprising a server (310) configured to coordinate execution of one or more the method steps according to claims 1 to 10, 12 and 13 executable in a distributed computing environment.

16. The system (300) according to claim 15, wherein the server (310) is further configured to:
initialize a fitting function for the fingerprint data based on at least one transformation function performed on the fingerprint data, wherein the transformation function results in at least one of a spectrogram of the fingerprint data and a FFT of the fingerprint data;
generate a trained unsupervised learning module according to claim 12; and
generate a trained autoencoder according to claim 13, wherein the server (310) is configured to store the fitting function, the transformation function, the trained autoencoder and the trained unsupervised learning module.

17. The apparatus (140, 140A-140C) according to claim 14 configured to detect at least one anomaly in the grid (110, 110A-110C) using at least one of the fitting function, the transformation function, the trained autoencoder and the trained unsupervised learning module generated by the server (310) according to claim 16.
